(19) Europäisches Patentamt

European Patent Office

Office européen des brevets

(11) **EP 1 672 672 A2**

(12) **EUROPEAN PATENT APPLICATION**

(43) Date of publication:
**21.06.2006 Bulletin 2006/25**

(51) Int Cl.:
**H01J 37/22** (2006.01)

(21) Application number: **05027647.6**

(22) Date of filing: **16.12.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **20.12.2004 JP 2004367222**

(71) Applicant: **Hitachi High-Technologies Corporation Tokyo 105-8717 (JP)**

(72) Inventors:
• **Ogashiwa, Takeshi,**
  **c/o Hitachi High-Tech. Corp.**
  **Hitachinaka-shi**
  **Ibaraki 312-8504 (JP)**
• **Sato, Mitsugu,**
  **c/o Hitachi High-Tech. Corp.**
  **Hitachinaka-shi**
  **Ibaraki 312-8504 (JP)**
• **Takane, Atsushi, ,**
  **c/o Hitachi High-Tech. Corp.**
  **Hitachinaka-shi**
  **Ibaraki 312-8504 (JP)**

(74) Representative: **Strehl Schübel-Hopf & Partner**
  **Maximilianstrasse 54**
  **80538 München (DE)**

(54) **Charged particle beam apparatus, method of displaying sample image, and method of measuring image shift sensitivity**

(57)    A sample image display method and an image shift sensitivity measuring method to be executed in a charged particle beam apparatus are provided for accurately correcting an image drift in any observing and analyzing condition such as an accelerating voltage, a working distance or a raster rotation. When obtaining a reference image used for detecting a drift, the process is executed to obtain an image having the different image shift amount from that of the reference image at a time and to occasionally measure an image shift sensitivity. Then, the process is executed to automatically register this reference image and the image shift sensitivity and to detect a drift amount and control an image shift (correct a drift) according to the registered conditions when correcting the drift.

FIG.1

EP 1 672 672 A2

**Description**

BACKGROUND OF THE INVENTION

The present invention relates to a charged particle beam apparatus, and more particularly to the charged particle beam apparatus and a method of displaying a sample image which are arranged to have a capability of accurately correcting an image drift that may bring about an obstacle to observation and erroneous analysis.

In the charged particle beam apparatus, an image drift (called a runaway of an image from a visual field or a shift of an image from a visual field) may take place on the screen where an observed image of a sample is displayed. The image drift means slow travel of an observed image with passage of time. This image drift is brought about by various factors taking place in the charged particle beam apparatus. For example, a sample stage on which a sample is loaded is thermally expanded by change of a temperature around the sample stage, so that the sample may be shifted from an optical axis. This shift may bring about an image drift. Further, if an insulative material is covered on the sample, the electrons entering into the sample are charged on the insulative material, so that the incident electrons may be influenced and the scanning and transmissive area of the incident electrons may be changed on the sample accordingly. This change may bring about the image drift.

On the other hand, the charged particle beam apparatus is used for observing a magnified image of a sample as well as analyzing a sample. As to the analyzing method, for example, an energy dispersive X-ray analyzing method (EDX) and a cathode luminescence (CL) method may be referred. The former method is as follows: When an electron beam that is one of the charged particle beams is applied onto a sample, a characteristic X-ray energy generated from the sample is captured and analyzed by a dedicated detector. This analysis results in being able to get to know the element composition on the sample. The latter method is as follows: When an electron beam is applied onto a sample, the ray of light generated from the sample is dispersed for analyzing some factors such as a wavelength. This analysis results in being able to get to know a chemical bonding state, crystalline defects, impurities and so forth of the sample.

In those analysis methods, by traveling a beam as analyzing an observing area on the sample one point by one point, it is possible to accumulate the analyzed result of each point of this observing area. In the EDX method and the CL method, for outputting these analyzed results in a visually recognized manner, the mapping method is used in which method the analyzed result of each point on the sample is outputted as an image signal in a two-dimensional manner. If the amount of signal detected for this analysis is small, it often needs several hours or more for obtaining a mapping image. If the image drift takes place when obtaining this mapping image, the mapping image is shifted from the sample to be analyzed. If this shift is large, this results in analyzing the sample located differently from the sample located at a target spot. In such a case, the analyzed result is made erroneous. Hence, it has been necessary to match the analysis location to the sample location that will become a new target and to retry the analysis from the outset.

In order to prevent this error, it has been necessary to deliberately make the sample stage stable as paying attention to the environmental factors around the apparatus such as a room temperature or consume lot of time in the pre-process of the sample. Further, even if the image drift takes place, the mapping method has been forced to be used only at as low an observation magnification as preventing the adverse effect on the analyzed result applied by the image drift.

In order to prevent an erroneous analyzed result, some methods have been conventionally provided as a technology of correcting the image drift if any. For example, in the system located on the side of the analyzing apparatus for obtaining the mapping image, a method has been provided of periodically obtaining an image used for detecting a drift amount and modifying the analyzed area so that this drift may be corrected. Further, as disclosed in the Official Gazette of JP-A-2003-7247, in the system located in a scanning electron microscope, there has been provided a method having the functions of periodically obtaining an observed image used for detecting the drift amount, converting the drift amount derived from this observed image through the image treatment into the movement amount of the electron beam on the sample, and shifting the scanning location of the electron beam (the function of shifting the image), for automatically correcting the image drift.

SUMMARY OF THE INVENTION

The charged particle beam apparatus is arranged to change the operating condition set to the apparatus itself according to the observing object and the analyzing object of a sample. For correcting the image drift resulting from the thermal expansion of the sample stage or the charged sample, therefore, it is necessary to constantly execute the highly accurate correction in any condition (such as an accelerating voltage, a distance between a sample and an objective lens (WD: Working Distance)) selectively set according to various observing conditions and analyzing conditions and in the state of executing a view rotation function (raster rotation function).

Herein, in the system located on the side of the analyzing apparatus for obtaining a mapping image according to a prior art, the method of periodically obtaining an image used for detecting a drift amount and modifying the analyzing area so that this drift may be corrected requires the system of the apparatus for obtaining a mapping image to have a function of correcting the drift. This results in advantageously making the system of the analyzing apparatus bulkier and more costly.

On the other hand, in the system located on the scanning electron microscope, the method of periodically obtaining an observed image used for detecting a drift amount and correcting an image drift on the drift amount derived from the image through the use of the image shifting function has been required to accurately measure a traveling amount of an electron beam (image shift amount) on a sample with respect to a control parameter (control current) of the image shift function, that is, a sensitivity of an image shift in advance, and register the measured result in the scanning electron microscope system. Further, since the sensitivity of an image shift is variable according to the WD (Working Distance), for making use of the registered image shift sensitivity, it is necessary to set the WD provided when measuring this sensitivity. Disadvantageously, it means that the use of the fixed WD is required. Further, since the rotation of a visual field resulting from the raster rotation function causes the traveling direction of the image shift to be changed, as another disadvantage, the change of the operating amount of the raster rotation is impossible.

It is an object of the present invention to provide a charged particle beam apparatus which is arranged to overcome these disadvantages of the prior art and correct the image drift in any observing and analyzing condition such as an accelerating voltage, a working distance, and a raster rotation with high precision.

In carrying out the foregoing object, according to the present invention, for correcting a drift through the use of an image shift, by providing means of obtaining an image with a different image shift amount when obtaining a reference image used for detecting a drift, the image shift sensitivity and the operating direction on the screen can be occasionally measured. Further, another means is provided of automatically registering this reference image and the image shift sensitivity in the system of the charged particle beam apparatus and another means is provided of detecting a drift amount and executing the image shift control (drift correction) according to these registering conditions when correcting a drift.

According to the present invention, the image drift resulting from an obstacle to observation and an erroneous analysis can be corrected in any observing and analyzing condition such as an accelerating voltage, a working distance, and a raster rotation with high precision.

Other objects, features and advantages of the invention will become apparent from the following description of the embodiments of the invention taken in conjunction with the accompanying drawings.

BRIEF DESCRIPTION OF THE DRAWINGS

Fig. 1 is a schematic diagram showing a scanning electron microscope according to the present invention;
Figs. 2A to 2E are views showing the states of sample images displayed on a display device; and
Fig. 3 is a flowchart illustrating a flow of correcting an image drift according to the present invention.

DETAILED DESCRIPTION OF THE EMBODIMENTS

For correcting the image drift through the use of the image shift according to any observing and analyzing conditions (such as an accelerating voltage and a working distance) and a raster rotation with high precision, it is necessary to measure the sensitivity of the image shift with high precision. Herein, the description will be oriented to the method of measuring the sensitivity of the image shift through the use of the image treatment with high precision.

In the charged particle beam apparatus, normally, since an image shift is executed in the two-dimensional (X, Y) direction, an image shift coil (Xc, Yc) (image shift deflector) is used. Herein, considering the raster rotation, an image shift $W_{IS}$ on the charged particle beam apparatus against the control DAC ($X_{IS}$, $Y_{IS}$) of the image shift coil current for executing the image shift is represented in complex numbers as in the following expression (1).

[Expression 1]

$$W_{IS} = K \cdot (X_{IS} + j \cdot \varepsilon \cdot Y_{IS}) \qquad \cdots (1)$$

wherein K (complex number) in the expression (1) is a sensitivity coefficient of the image shift influenced by the raster rotation of the observed image and depends upon the observing and analyzing conditions, the raster rotation, and so forth. Assuming that in the image shift coil the beam deflecting direction (X, Y) corresponds with the scanning direction (X, Y), K is a real number. Further, $\varepsilon$ in the expression (1) is a complex parameter that represents a sensitivity ratio of an X coil (Xc) to a Y coil (Yx) of the image shift and an orthogonal shift between the X oil (Xc) and the Y coil (Yx). For the ideal image coil with no orthogonal shift and no asymmetric sensitivity, $\varepsilon = 1$ is established. In general, $\varepsilon$ is a complex number.

Herein, K and $\varepsilon$ are represented by the following expressions (2) and (3).

[Expression 2]

$$K = K_r + j \cdot K_i \qquad \cdots (2)$$

$$\varepsilon = \varepsilon_r + j \cdot \varepsilon_i \qquad \cdots (3)$$

For measuring the sensitivity coefficient (K) and coil coefficient ($\varepsilon$), the current DAC set values of the X coil and the Y coil are both changed by S (LSB), and a parallax (W) of the charged particle beam apparatus is measured through the effect of the image treatment. Table 1 indicates a relation between the parallax and the operating amount of the image shift (X, Y). In addition, the image processing technique of measuring this parallax W from two images between which the parallax appears is, for example, a correlation-based method, which is a known art.

[Table 1] Relation between Image Shift Operating Amount and Parallax

| X (LSB) | Y (LSB) | W (Parallax Detected) | Expression (1) |
|---|---|---|---|
| 0 | 0 | 0 (Reference Image) | 0 |
| S | 0 | $W_1 = W_{1x} + jW_{1y}$ | K•S |
| 0 | S | $W_2 = W_{2x} + jW_{2y}$ | j•K•$\varepsilon$•S |

From that known art, the sensitivity coefficient and the coil coefficient (sensitivity parameter) of the image shift are calculated by the following expression.

[Expression 3]

$$W_1 = KS \quad ,$$

therefore,

$$K = K_r + jK_i = \frac{W_1}{S} = \frac{W_{1x} + jW_{1y}}{S} \qquad \cdots (4)$$

$$W_2 = jK\varepsilon S \quad ,$$

therefore,

$$\varepsilon = -j\frac{W_2}{KS} = -j\frac{W_2}{W_1} = \frac{1}{W_{1x}^2 + W_{1y}^2} \cdot \left[(W_{1x}W_{2y} - W_{2x}W_{1y}) - j(W_{2x}W_{1x} + W_{2y}W_{1y})\right] \quad \cdots(5)$$

From the coefficients of the expressions (4) and (5), the operating amount of the image shift (control DAC ($X_{IS}$, $Y_{IS}$) of the image shift coil current) that realizes any visual field shift W (= $W_x$ + $jW_y$) is calculated as follows.

[Expression 4]

$$X_{IS} + j\varepsilon Y_{IS} = \frac{W}{K} \quad ,$$

therefore,

$$X_{IS} - \varepsilon_i Y_{IS} = \text{Re}\left[\frac{W}{K}\right]$$

$$\varepsilon_r Y_{IS} = \text{Im}\left[\frac{W}{K}\right]$$

Therefore,

$$Y_{IS} = \frac{1}{\varepsilon_r}\text{Im}\left[\frac{W}{K}\right] \quad \cdots(6)$$

$$X_{IS} = \varepsilon_i Y_{IS} + \text{Re}\left[\frac{W}{K}\right] = \frac{\varepsilon_i}{\varepsilon_r}\text{Im}\left[\frac{W}{K}\right] + \text{Re}\left[\frac{W}{K}\right] \quad \cdots(7)$$

The use of the foregoing method makes it possible to measure the sensitivity of the image shift with high precision and thus to correct the image drift through the use of the image shift according to any observing and analyzing condition with high precision. In the foregoing example, for measuring the sensitivity coefficient (K) and the coil coefficient ($\varepsilon$) of the image shift coil are obtained the reference image and the two images in which the current DAC set values of the X coil and the Y coil are changed by S(LSB) with respect to each other. Instead, it is possible to take the method of obtaining three or more images in which the current DAC set values of the X coil and the Y coil are changed with respect to each other and using an average value of the sensitivity coefficient (K) and the coil coefficient ($\varepsilon$) of the image shift calculated from the reference image and the parallax formed by these three images as the sensitivity of the image shift.

Hereafter, an embodiment of the present invention will be described in detail with reference to the appended drawings. The description will be concerned with the application of the present invention to the scanning electron microscope. In actual, however, the present invention may be applied to not only the scanning electron microscope but also any kind of charged particle beam apparatus provided with an image shift function such as a focusing ion beam apparatus (FIB), a scanning transparent electron microscope (STEM) and a transparent electron microscope.

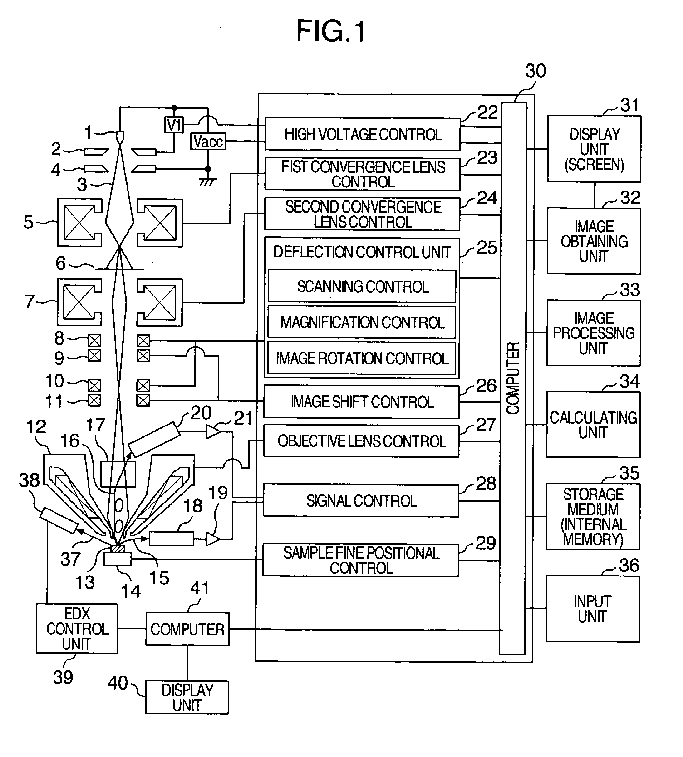

Fig. 1 is a schematic diagram showing a scanning electron microscope in which a field-emission electron gun is loaded according to the present invention. The effect of the present invention is not limited by the loaded electron gun. A primary electron beam 3, emitted from a cathode 1 by a voltage V1 applied onto the cathode 1 and a first anode 2, is accelerated by a voltage Vacc applied onto a second cathode 4 and then travels to an electromagnetic lens system located at a later stage. This accelerated voltages Vacc and V1 are controlled by a high voltage control circuit 22. The primary electron beam 3 is converged through a first convergence lens 5 controlled by a first convergence lens control circuit 23. The glancing angle (irradiation angle) of the converged beam 3 is restricted by an objective lens iris diaphragm 6. Then, the converged beam is further converged through a second convergence lens 7 controlled by a second convergence lens control circuit 24. The converged beam is irised onto a sample 13 through an objective lens 12 controlled by an objective lens control circuit 27. Further, the beam is two-dimensionally scanned on the sample 13 through the effect of two-step deflection coils 8 and 10 controlled by a deflection control unit 25 composed of a scan control circuit, a magnification control circuit and a visual field rotation control circuit. Further, the scanning location of the primary electron beam 3 may be shifted by the two-step image shift coils 9 and 11 controlled by an image shift control circuit 26. Herein, the sample 13 is located on a sample fine positional control device 14 controlled by a sample fine positional control circuit 29.

The signal generated from a primary electron beam irradiation point of the sample 13 contains a reflective electron signal 15 having high energy emitted at a relatively shallow angle and a secondary electron signal 16 having low energy. The reflective electron signal 15 is detected by a detector 18 and amplified by an amplifier 19. The secondary electron signal 16 is detected by a detector 20 and then amplified by an amplifier 21 without bringing about an axial shift of the primary electron beam by an orthogonal electromagnetic field (EXB) device 17 located at the upper portion of the objective lens and wound up by a magnetic field of the objective lens 12. The amplifiers 19 and 21 are controlled by a signal control circuit 28. Those control circuits 22 to 29 are controlled by a computer 30 for controlling the overall apparatus. The signals of the amplified secondary electrons and reflective electrons are displayed as a magnified image of the sample on the screen of a display device 31.

The computer 30 is connected with an image obtaining unit 32 for obtaining an observed image displayed on the display device 31 as image information, an image processing unit 33 for performing various image treatments with respect to the observed images, a calculating unit 34 for calculating sensitivity parameters of the image shift by the foregoing method and performing various calculations, an internal memory 35 for storing the observed images and the calculated results, and an input unit 36 that is supplied with the observing condition and the like. Further, the scanning electron microscope is connected with a detector 38 of an energy dispersive X-ray analyzing device (EDX) for performing an analysis through the use of the X ray 37 generated from the primary electron beam irradiation point of the sample 13, the analyzing device served as an analyzing device for analyzing the elements of the sample 13, an EDX control device 39, a display device 40 for displaying the analyzed result like a mapping image, and a computer 41 for the EDX. This EDX computer is connected with the computer 30 connected with the scanning electron microscope through a communication line so that a control instruction may be transferred between these computers. The EDX computer 41 enables to transmit an instruction of calculating the image shift sensitivity parameter and correcting the drift to the computer 30 for controlling the scanning electron microscope. In addition, the control circuits and the computers for controlling those units may be generally called a control device.

The effect of the present invention is not limited by the connected analyzing device.

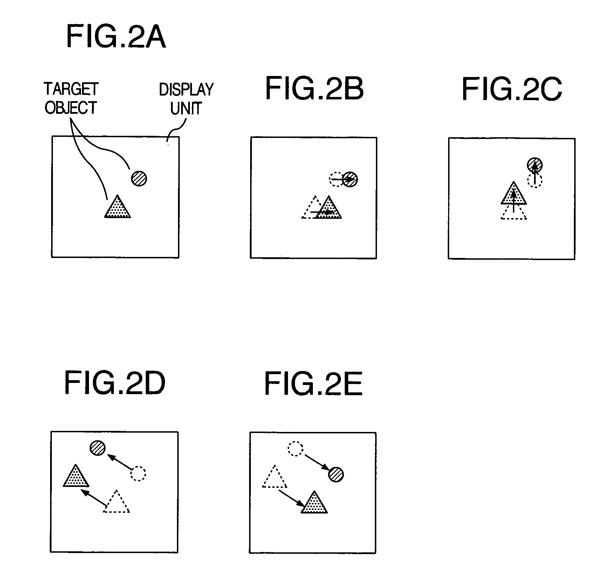

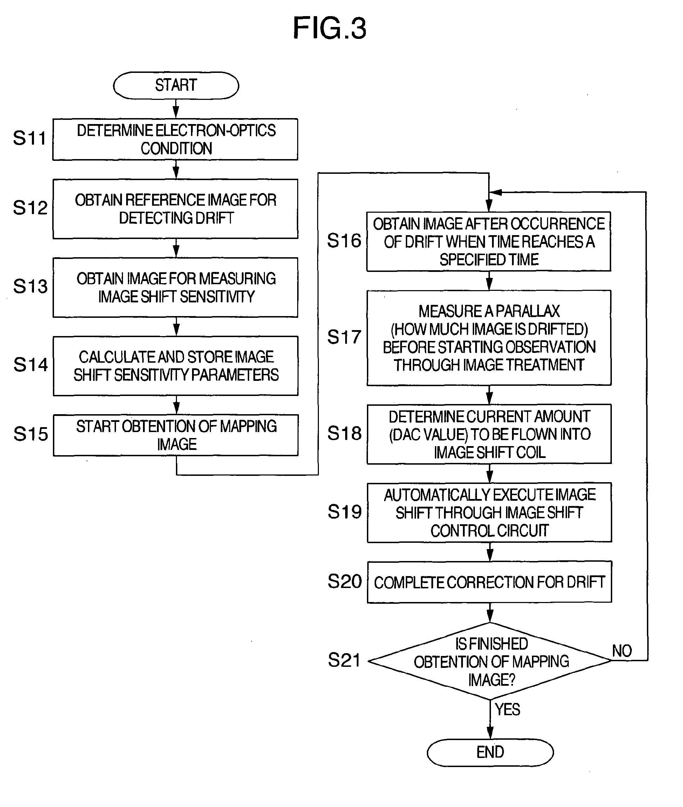

The actual drift correction to be executed in the case of generating an image drift when obtaining a mapping image will be described along the flowchart of Fig. 3 that indicates a flow of drift correction to be executed in this embodiment. Figs. 2A to 2F show the states of the sample images. Those figures are often used for the description if necessary.

An operator determines the condition for observation and analysis of each sample with an input unit 36. On the determined condition, the electron-optics conditions (such as an accelerating voltage and a working distance) and the raster rotation angle are determined (S11). These conditions are set by the computer 30. Afterwards, before starting the mapping, the following process is to be executed.

At first, as shown in Fig. 2A, when the display device 31 displays a sample image in which a target object to be analyzed enters into a visual field, the image obtaining unit 32 obtains a reference image to be used for detecting an image drift and then stores the reference image in the storage unit 35 (S12).

Next, the operation is executed to obtain an image to be used for measuring an image shift sensitivity. In a case that the control DAC value of the image shift coil current appearing when obtaining the reference image is ($X_{ISO}$,

$Y_{ISO}$), the control DAC value of $(X_{ISO}+S, Y_{ISO})$ is set to the image shift control circuit 26. This results in shifting the scanning location of the primary electron beam 3 on the sample 13. As shown in Fig. 2B, therefore, the sample image displayed on the display device 31 is shifted. This sample image is obtained by the image obtaining unit 32 and then is stored in the storage unit 35. Likewise, the control DAC value of $(X_{ISO}, Y_{ISO}+S)$ is set to the image shift control circuit 26. As shown in Fig. 2C, the shifted sample image displayed on the display device 31 is obtained by the image obtaining unit 32 and then stored in the storage unit 35 (S13).

Next, the parallaxes W1 and W2 of each image for measurement against the reference image, which are obtained by the foregoing process, are measured by using the image processing unit 33. The image shift sensitivity parameters are calculated from these parallaxes W1 and W2 through the effect of the expressions (4) and (5). This calculation is carried out by the calculating unit 34 provided with the method of calculating the image shift sensitivity parameters. The calculated parameters are stored in the storage unit 35 (S14).

By executing the foregoing process before obtaining the mapping image, it is possible to obtain the image shift sensitivity against any electron-optics condition set by the operator in advance. Further, if the electron-optics condition is reset for changing the condition for observation and analysis, the foregoing process is executed again at least once.

It is assumed that the obtention of the mapping image is started (S15) and the drift takes place. When the time reaches a specified time, the sample image after the drift displayed on the display device 31 is obtained by the image obtaining unit 32 and then is stored in the storage unit 35 (S16). The parallax between this obtained image and the reference image is measured by the image processing unit 33 (S17).

For executing the equal amount of image shift to this parallax, the control DAC value of the image shift coil current is calculated through the expressions (6) and (7) by the calculating unit 34 provided with the method of calculating the image shift operating amount that realizes the visual field shift W (S18). By setting this DAC value to the image shift control circuit, the image shift is automatically carried out (S19).

As described above, as shown in Fig. 2E, the sample image is returned into the same state as the image before occurrence of the drift so that the image drift may be corrected (S20). If the process of obtaining the mapping image is not terminated, the process goes back to the state after starting the obtention of the mapping image but before occurrence of the drift. Then, the flow of the drift correction is repeated (S21).

In this embodiment, even under any electron-optics condition such as an accelerating voltage, a working distance or a raster rotation, the image drift may be automatically corrected with high precision. In addition, this embodiment has been described with an example of obtaining the mapping image. Instead, in the case of observing a sample image for a long time, the same effect may be obtained.

It should be further understood by those skilled in the art that although the foregoing description has been made on embodiments of the invention, the invention is not limited thereto and various changes and modifications may be made without departing from the spirit of the invention and the scope of the appended claims.

**Claims**

1.    A charged particle beam apparatus comprising:

   a charged particle beam source (1, 2, 4);
   a lens system (5, 9) for converging a primary charged particle beam irradiated from said charged particle beam source;
   a detector unit (18, 20) for detecting a signal generated from a sample by said irradiated primary charged particle beam;
   a display unit (40) for displaying a magnified image of said sample through the use of an output signal of said detector;
   an image shift deflector unit (10, 11) for moving a visual field of said magnified image by moving an irradiated area of said primary charged particle beam; and
   a control unit (30) for comparing a plurality of images whose image shift amounts are different, obtained by said image shift deflector, with each other and thereby measuring an operating sensitivity of said image shift deflector.

2.    A charged particle beam apparatus as claimed in claim 1, further comprising a deflector (8, 9) for scanning said primary charged particle beam on said sample.

3.    A charged particle beam apparatus as claimed in claim 1, wherein said control unit obtains a reference image and a plurality of images whose moving directions are different and in which the image shift operating amounts against said reference image obtained by said image shift deflector (10, 11) are known.

**4.** A charged particle beam apparatus as claimed in claim 3, wherein said control unit measures an operating sensitivity of said image shift deflector by an operation based on a shift between said reference image and a plurality of images whose moving directions are different and in which said image shift operating amounts are known.

**5.** A charged particle beam apparatus as claimed in claim 4, further comprising a storage medium (35) for storing an operating sensitivity of said image shift deflector.

**6.** A charged particle beam apparatus as claimed in claim 5, wherein said control unit calculates an operating amount of said image shift deflector required for correcting a shift amount between said reference image stored by said storage medium and a current sample image obtained in the same image shift operating condition as said reference image from said shift amount and an operating sensitivity of said image shift deflector stored in said storage medium and controls the operation of said image shift deflector to match the operation of said deflector to said calculated operating amount.

**7.** A sample image display method of displaying a magnified image of a sample through the use of a signal obtained from said sample by an irradiated primary charged particle beam, comprising the steps of:

controlling an image shift deflector for moving a visual field of said magnified image by moving an irradiated area of said primary charged particle beam and obtaining a reference image and a plurality of images whose image shift directions are different and in which the image shift operating amounts against said reference image obtained by said image shift deflector are known (S11, S12, S13); and
measuring an operating sensitivity of said image shift deflector based on a shift between said reference image and a plurality of images whose directions are different and in which said image shift operating amounts against said reference image are known (S14, S15).

**8.** A sample image display method as claimed in claim 7, further comprising the step (S14) of storing said reference image and said measured operating sensitivity of said image shift deflector.

**9.** A sample image display method as claimed in claim 8, further comprising the steps of:

re-obtaining a sample image in the same image shift operating condition as said reference image (S16) ;
detecting a shift between said re-obtained sample image and said reference image (S17);
calculating an operating amount of said image shift deflector required for correcting said shift between said images from said detected shift between said images and an operating sensitivity of said image shift deflector (S18); and
controlling said image shift deflector to match the operation of said image shift deflector to said calculated operating amount (S19).

**10.** A sample image display method as claimed in claim 9, wherein the process of said each step is executed in response to an instruction from another device received through a communication line.

**11.** A sample image display method as claimed in claim 8, wherein when changing the optical condition for irradiating said primary charged particle beam to said sample, the process of said each step is executed.

**12.** A method of measuring a sensitivity of said image shift deflector for moving a visual field by moving an irradiated area of a primary charged particle beam emitted from a charged particle beam source, said image shift deflector included in a charged particle beam apparatus for displaying a magnified image of said sample by using a signal generated from said sample by said irradiated primary charged particle beam, comprising the steps of:

obtaining a first sample image as setting the operating condition of said image shift deflector as the reference first condition;
obtaining a second sample image as setting the operating condition of said image shift deflector as the different second condition as said first condition;
obtaining a third sample image as setting the operating condition of said image shift deflector to the different third condition from said first and second conditions;
detecting a first shift between said first sample image and said second sample image;
detecting a second shift between said first sample image and said third sample image; and
calculating a sensitivity of said image shift deflector by applying said first and second shifts to an equation that represents relation between change of the operating condition of said image shift deflector and an image shift amount.

# FIG.1

| | |
|---|---|
| HIGH VOLTAGE CONTROL | 22 |
| FIST CONVERGENCE LENS CONTROL | 23 |
| SECOND CONVERGENCE LENS CONTROL | 24 |
| DEFLECTION CONTROL UNIT | 25 |
| SCANNING CONTROL | |
| MAGNIFICATION CONTROL | |
| IMAGE ROTATION CONTROL | |
| IMAGE SHIFT CONTROL | 26 |
| OBJECTIVE LENS CONTROL | 27 |
| SIGNAL CONTROL | 28 |
| SAMPLE FINE POSITIONAL CONTROL | 29 |

COMPUTER 30

| | |
|---|---|
| DISPLAY UNIT (SCREEN) | 31 |
| IMAGE OBTAINING UNIT | 32 |
| IMAGE PROCESSING UNIT | 33 |
| CALCULATING UNIT | 34 |
| STORAGE MEDIUM (INTERNAL MEMORY) | 35 |
| INPUT UNIT | 36 |

EDX CONTROL UNIT 39

COMPUTER 41

DISPLAY UNIT 40

FIG.2A

TARGET
OBJECT

DISPLAY
UNIT

FIG.2B

FIG.2C

FIG.2D

FIG.2E

# FIG.3

START

S11 | DETERMINE ELECTRON-OPTICS CONDITION

S12 | OBTAIN REFERENCE IMAGE FOR DETECTING DRIFT

S13 | OBTAIN IMAGE FOR MEASURING IMAGE SHIFT SENSITIVITY

S14 | CALCULATE AND STORE IMAGE SHIFT SENSITIVITY PARAMETERS

S15 | START OBTENTION OF MAPPING IMAGE

S16 | OBTAIN IMAGE AFTER OCCURRENCE OF DRIFT WHEN TIME REACHES A SPECIFIED TIME

S17 | MEASURE A PARALLAX (HOW MUCH IMAGE IS DRIFTED) BEFORE STARTING OBSERVATION THROUGH IMAGE TREATMENT

S18 | DETERMINE CURRENT AMOUNT (DAC VALUE) TO BE FLOWN INTO IMAGE SHIFT COIL

S19 | AUTOMATICALLY EXECUTE IMAGE SHIFT THROUGH IMAGE SHIFT CONTROL CIRCUIT

S20 | COMPLETE CORRECTION FOR DRIFT

S21 | IS FINISHED OBTENTION OF MAPPING IMAGE? — NO

YES

END